# EUROPEAN PATENT SPECIFICATION

(11) **EP 3 261 365 B1**
(45) Date of publication and mention of the grant of the patent: **13.11.2019**
(21) Application number: 16752402.4
(22) Date of filing: 12.02.2016
(51) Int. Cl.: H04R 17/00, G01S 7/521, H01L 41/047, H01L 41/053, H01L 41/113

(54) **ULTRASONIC SENSOR**
ULTRASCHALLSENSOR
CAPTEUR ULTRASONIQUE

(30) Priority: 16.02.2015 JP 2015027324
(43) Date of publication of application: 27.12.2017
(73) Proprietor: Murata Manufacturing Co., Ltd., Nagaokakyo-shi, Kyoto 617-8555 (JP)
(72) Inventor: NANBU, Koji, Nagaokakyo-shi Kyoto 617-8555 (JP)
(74) Representative: Reeve, Nicholas Edward
(86) International application number: PCT/JP2016/054115
(87) International publication number: WO 2016/133016

(56) References cited:
- EP-A1- 2 765 789
- EP-A1- 2 775 735
- JP-A- H07 194 517
- JP-A- H11 135 852
- JP-A- 2002 204 497
- JP-A- 2006 187 067

## Description

### Technical Field

The present invention relates to an ultrasonic sensor including a piezoelectric element.

### Background Art

A general ultrasonic sensor provides a unimorph structure by joining a piezoelectric element to an inner bottom surface of a case and transmits and receives ultrasonic waves by causing the bottom portion of the case to perform bending vibration. Japanese Patent Laying-Open No. 2002-204497) discloses an ultrasonic sensor including a multilayer piezoelectric element.

Further, WO2013051525 (published also as EP2765789 A; see Fig. 5 there) discloses an ultrasonic sensor with the features of the preamble of claim 1, in particular a cylindrical, electrically conductive case, and a piezoelectric element (but no multilayer piezoelectric element) bonded into a recess in an inner bottom surface of the case. The lower electrode of the piezoelectric element is grounded via the case.

Let us assume that a multilayer piezoelectric element is bonded to an inner bottom surface of a case having conductivity. In this case, a grounded electrode and an ungrounded electrode (an end portion of an end face electrode) that forms a potential difference between the grounded electrode and the ungrounded electrode by application of a voltage are located at the bonding surface side of the piezoelectric element. In the case of a conventional ultrasonic sensor, the case having conductivity and the ungrounded electrode (the end portion of the end face electrode) establish electrical conduction and a counter electrode circuit (an electrical circuit for forming the ultrasonic sensor) is not appropriately formed in some cases.

We have appreciated that it would be desirable to provide an ultrasonic sensor capable of suppressing electrical conduction established by a case and an ungrounded electrode (an end portion of an end face electrode) even when a multilayer piezoelectric element is bonded to an inner bottom surface of a case having conductivity.

### SUMMARY OF INVENTION

An ultrasonic sensor according to the present invention includes: a case having electrical conductivity and having a cylindrical shape with a bottom; and a multilayer piezoelectric element bonded to an inner bottom surface of the case, a grounded electrode and an ungrounded electrode adapted to form a potential difference between the grounded electrode and the ungrounded electrode by application of a voltage to the ungrounded electrode, a lower surface portion of the grounded electrode being located at a bonding surface side of the piezoelectric element, a recessed portion being formed in the inner bottom surface of the case, in a plan view of the ungrounded electrode and the recessed portion along a direction perpendicular to the inner bottom surface of the case, and an end portion of the ungrounded electrode located at the bonding surface side being located to overlap with the recessed portion.

Preferably, in a plan view of the ungrounded electrode and the recessed portion along the direction perpendicular to the inner bottom surface of the case, the end portion of the ungrounded electrode located at the bonding surface side is located to be included inside the recessed portion.

Preferably, the piezoelectric element has a rectangular parallelepiped shape including a longer side direction and a shorter side direction, and the end portion of the ungrounded electrode located at the bonding surface side has a shape extending along the longer side direction of the piezoelectric element.

Preferably, the piezoelectric element has a rectangular parallelepiped shape including a longer side direction and a shorter side direction, and the end portion of the ungrounded electrode located at the bonding surface side has a shape extending along the shorter side direction of the piezoelectric element.

Preferably, a through hole is provided in a bottom portion of the case and a resin is filled into the through hole to form the recessed portion.

Preferably, the piezoelectric element has: a piezoelectric layer including a transmission region and a reception region; a common electrode having a shape extending over both the transmission region and the reception region; a transmission electrode opposing the common electrode with the transmission region interposed therebetween; and a reception electrode opposing the common electrode with the reception region interposed therebetween, and the transmission region and the reception region are formed at positions adjacent to each other in a surface direction of the inner bottom surface.

According to the above-described configuration, electrical conduction established by the ungrounded electrode (the end portion of the end face electrode) and the case is suppressed by the presence of the recessed portion, and thus, the counter electrode circuit (the electrical circuit for forming the ultrasonic sensor) can be appropriately formed.

### BRIEF DESCRIPTION OF DRAWINGS

Fig. 1 is a diagram illustrating functional blocks of a sensor device including an ultrasonic sensor in a first embodiment.
Fig. 2 is a cross-sectional view illustrating the ultrasonic sensor in the first embodiment.
Fig. 3 is a plan view illustrating a piezoelectric element and a flexible printed circuit (FPC) included in the ultrasonic sensor in the first embodiment.
Fig. 4 is a plan view illustrating the piezoelectric element (in a state in which the FPC is detached) included in the ultrasonic sensor in the first embodiment.
Fig. 5 is a perspective view illustrating the piezoelectric element included in the ultrasonic sensor in the first embodiment.
Fig. 6 is a perspective view illustrating the piezoelectric element included in the ultrasonic sensor and the internal structure thereof in the first embodiment.
Fig. 7 is a perspective view illustrating electrodes included in the piezoelectric element of the ultrasonic sensor in the first embodiment.
Fig. 8 is a cross-sectional view when seen in an arrow direction along a line VIII-VIII in Fig. 4.
Fig. 9 is a cross-sectional view when seen in an arrow direction along a line IX-IX in Fig. 4.
Fig. 10 is a cross-sectional view when seen in an arrow direction along a line X-X in Fig. 4.
Fig. 11 is a plan view illustrating a state when a bottom portion (inner bottom surface) of a case used for the ultrasonic sensor in the first embodiment is seen along a direction perpendicular to the bottom portion.
Fig. 12 is a plan view illustrating a state when a bottom portion (inner bottom surface) of a case used for an ultrasonic sensor in a second embodiment is seen along a direction perpendicular to the bottom portion.
Fig. 13 is a plan view illustrating a state when a bottom portion (inner bottom surface) of a case used for an ultrasonic sensor in a third embodiment is seen along a direction perpendicular to the bottom portion.
Fig. 14 is a plan view illustrating a state when a bottom portion (inner bottom surface) of a case used for an ultrasonic sensor in a fourth embodiment is seen along a direction perpendicular to the bottom portion.
Fig. 15 is a cross-sectional view illustrating a case and the like used for an ultrasonic sensor in a fifth embodiment.
Fig. 16 is a perspective view illustrating a piezoelectric element used for an ultrasonic sensor in a sixth embodiment.

### DESCRIPTION OF EMBODIMENTS

Embodiments based on the present invention will be described hereinafter with reference to the drawings. When the number and an amount of components are referred, the scope of the present invention is not necessarily limited to the number and the amount of them unless otherwise specified. The same reference numerals denote the same components and equivalent components and overlapped description thereof is not repeated in some cases.

### First Embodiment

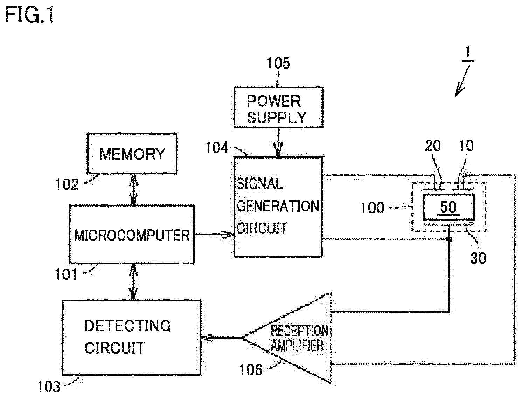

Fig. 1 is a diagram illustrating functional blocks of a sensor device 1 including an ultrasonic sensor 100 in a first embodiment. Sensor device 1 includes ultrasonic sensor 100, a microcomputer 101, a memory 102, a detecting circuit 103, a signal generation circuit 104, a power supply 105, and a reception amplifier 106. Ultrasonic sensor 100 includes a piezoelectric element 50, and piezoelectric element 50 has a three-terminal structure formed of electrodes 10, 20, and 30.

Microcomputer 101 reads out data stored in memory 102 and outputs a control signal to signal generation circuit 104. Signal generation circuit 104 generates an alternating-current (AC) voltage from the DC voltage based on the control signal. The AC voltage is supplied to ultrasonic sensor 100 and ultrasonic waves are transmitted into the air or the like from ultrasonic sensor 100. When ultrasonic sensor 100 receives reflected waves from a target, a reception signal generated in ultrasonic sensor 100 as a voltage value is transmitted to reception amplifier 106 and is input to microcomputer 101 through detecting circuit 103. Information related to presence or absence and movement of the target can be grasped with microcomputer 101.

### (Ultrasonic Sensor 100)

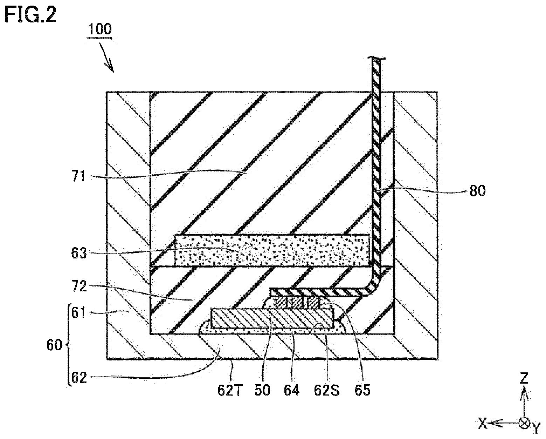

Fig. 2 is a cross-sectional view illustrating ultrasonic sensor 100 in the first embodiment. Ultrasonic sensor 100 includes a piezoelectric element 50, a case 60, a sound absorbing material 63, an adhesive 64, a bonding agent 65, fillers 71 and 72, and a flexible printed circuit (FPC) 80. Case 60 is formed to have conductivity and have a cylindrical shape with a bottom. Case 60 is made of aluminum that has high elasticity and is lightweight, for example. Case 60 is produced by performing forging processing or cutting processing on aluminum, for example.

Case 60 includes a disk-like bottom portion 62 and a cylindrical portion 61 provided along a peripheral edge of bottom portion 62 and formed in a cylindrical shape. Bottom portion 62 has an inner bottom surface 62S and an outer surface 62T. Piezoelectric element 50 is made of PZT-based ceramics, for example. Piezoelectric element 50 is arranged on inner bottom surface 62S of bottom portion 62 and is bonded to inner bottom surface 62S using adhesive 64. Adhesive 64 is an epoxy-based adhesive, for example. When ultrasonic sensor 100 is driven, piezoelectric element 50 performs bending vibration together with bottom portion 62.

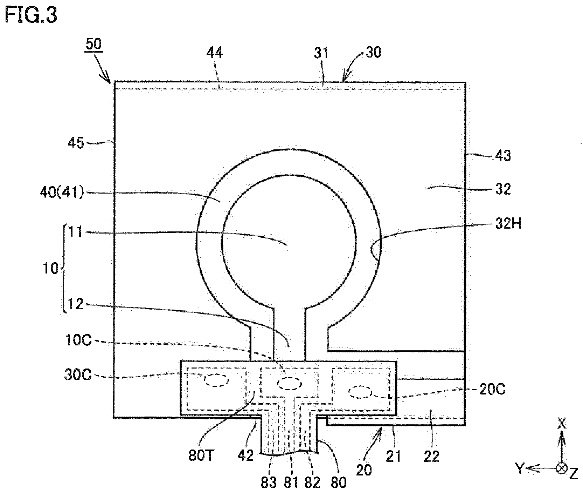

Piezoelectric element 50 includes three electrodes (not illustrated) (corresponding to electrodes 10 to 30 in Fig. 1, and details thereof will be described later). As illustrated in Fig. 3, a leading end portion 80T of FPC 80 has a T shape. FPC 80 is electrically bonded to these electrodes with bonding agent 65 interposed therebetween. A resin material to which metal has been added is used as bonding agent 65, for example. A portion of FPC 80 at the side opposite to a portion thereof bonded to piezoelectric element 50 is extended to the outside of case 60 and is electrically connected to signal generation circuit 104 (Fig. 1), reception amplifier 106 (Fig. 1), and the like.

### (Piezoelectric Element 50)

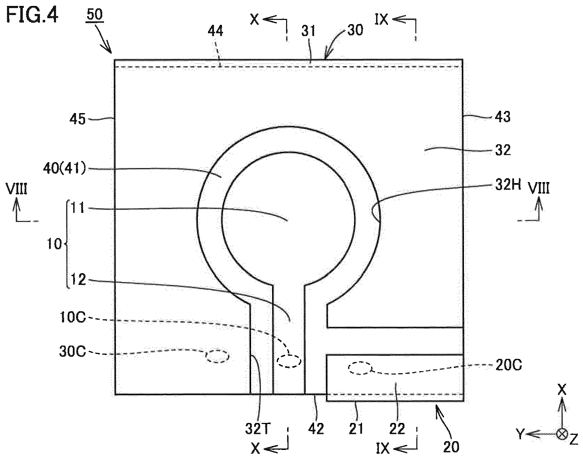

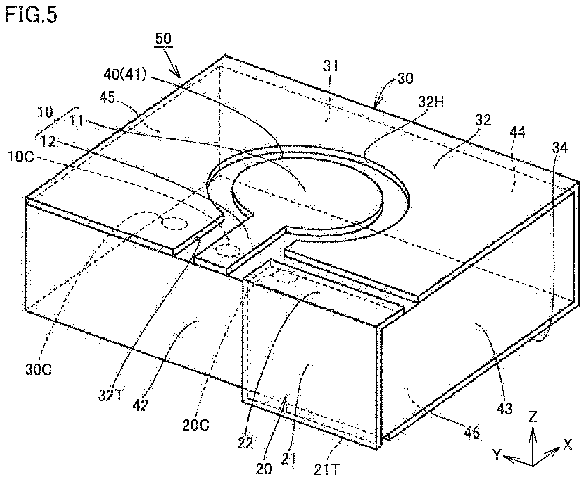

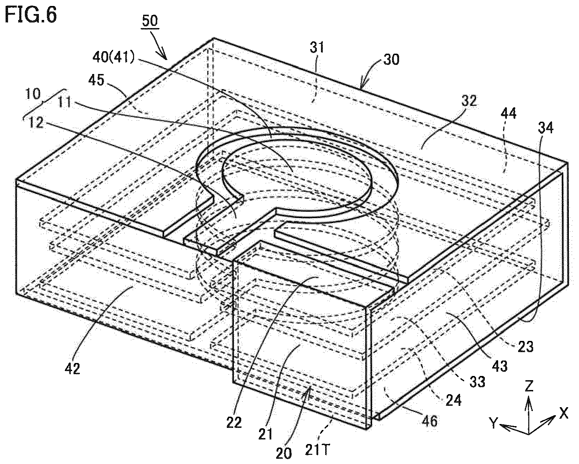

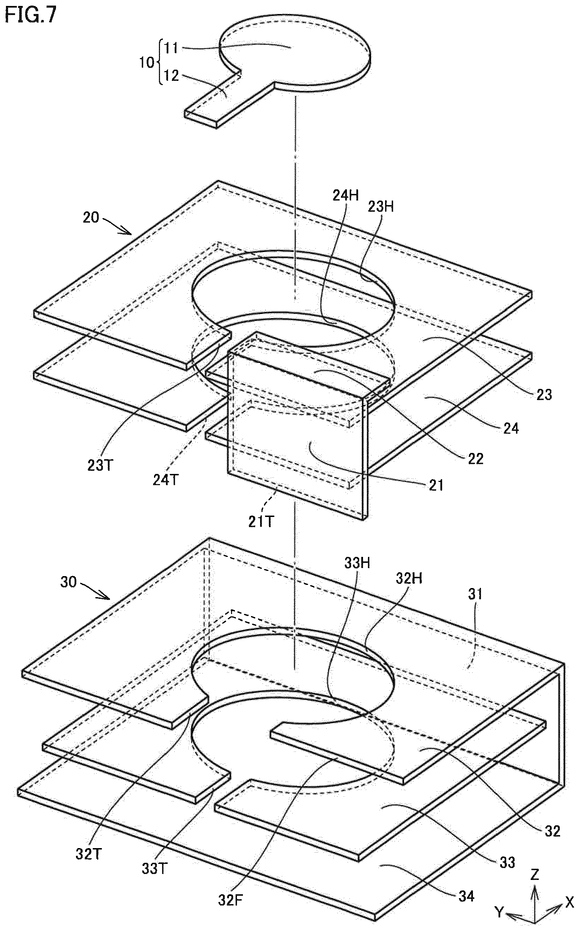

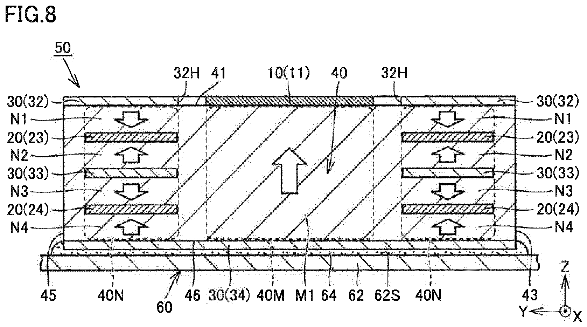

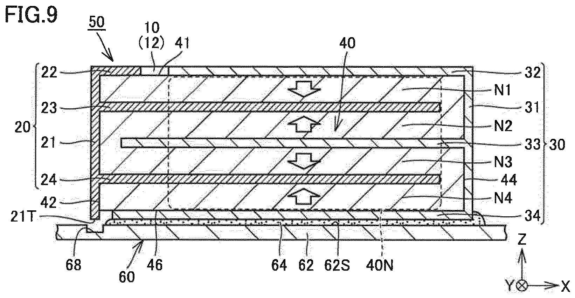

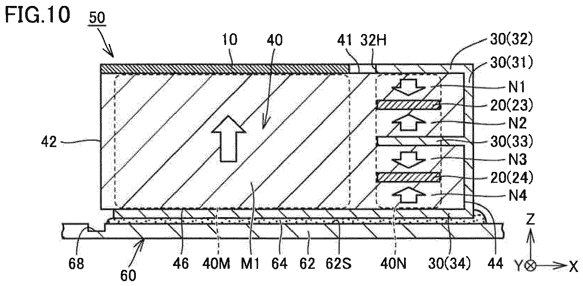

Fig. 3 is a plan view illustrating piezoelectric element 50 and FPC 80. Fig. 4 is a plan view illustrating piezoelectric element 50 (in a state in which FPC 80 is detached). Fig. 5 is a perspective view illustrating piezoelectric element 50. Fig. 6 is a perspective view illustrating piezoelectric element 50 and the internal structure thereof. Fig. 7 is a perspective view illustrating electrodes 10, 20, and 30 included in piezoelectric element 50. Fig. 8 is a cross-sectional view when seen in the arrow direction along a line VIII-VIII in Fig. 4. Fig. 9 is a cross-sectional view when seen in the arrow direction along a line IX-IX in Fig. 4. Fig. 10 is a cross-sectional view when seen in the arrow direction along a line X-X in Fig. 4.

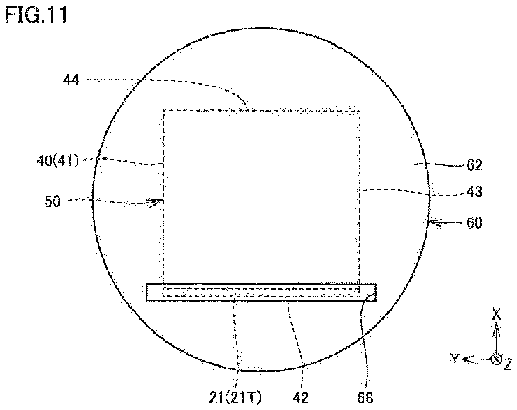

In Fig. 3 to Fig. 10, arrows X, Y, and Z are indicated for the convenience of description. As shown, arrows X, Y, and Z have a relation of being orthogonal to one another. Hereinafter, the respective configurations of piezoelectric element 50 are described with reference to arrows X, Y, and Z in some cases. However, arrangement relations of the respective configurations (characteristics related to orthogonality and parallelism) are not necessarily limited to arrangement relations as indicated by arrows X, Y, and Z. The same applies as well to Fig. 11 to Fig. 16 described later.

As illustrated in Fig. 3 to Fig. 10, piezoelectric element 50 is a multilayer piezoelectric element and is attached to inner bottom surface 62S of case 60 using adhesive 64. Piezoelectric element 50 has a rectangular parallelepiped shape including a longer side direction and a shorter side direction. Specifically, piezoelectric element 50 includes a piezoelectric layer 40 (Fig. 3 to Fig. 6 and Fig. 8 to Fig. 10), electrode 10 (Fig. 7), electrode 20 (Fig. 7) as an ungrounded electrode, and electrode 30 (Fig. 7) as a grounded electrode. The outer shape of piezoelectric layer 40 is a substantially rectangular parallelepiped shape (see Fig. 5 and Fig. 6) and piezoelectric layer 40 has an upper surface 41, side surfaces 42 to 45, and a lower surface 46.

Upper surface 41 is a surface of piezoelectric layer 40, which is located at the arrow Z direction side. Lower surface 46 is a surface of piezoelectric layer 40, which is located at the opposite direction side to the arrow Z direction. Side surfaces 42 and 44 are surfaces of piezoelectric layer 40, which are orthogonal to the arrow X direction, and have a positional relation of opposing each other. Side surfaces 43 and 45 are surfaces of piezoelectric layer 40, which are orthogonal to the arrow Y direction, and have a positional relation of opposing each other.

### (Electrode 10)

Electrode 10 includes a disk portion 11 and an extending portion 12 (see Fig. 7). Electrode 10 functions as a reception electrode. Extending portion 12 has a shape extending toward the outer side from the outer edge of disk portion 11. Extending portion 12 is arranged so as to extend toward the side at which side surface 42 of piezoelectric layer 40 is located from the side at which disk portion 11 is located. As illustrated in Fig. 3, electrode 10 and FPC 80 (wiring pattern 81) are electrically connected on a portion (connecting place 10C) between wiring pattern 81 provided in FPC 80 and extending portion 12 of electrode 10 (also see Fig. 4 and Fig. 5).

### (Electrode 20 (Ungrounded Electrode))

Electrode 20 as an ungrounded electrode includes an end face portion 21, an upper surface portion 22, and intermediate portions 23 and 24 (see Fig. 7). Electrode 20 functions as a transmission electrode. That is to say, electrode 20 forms a potential difference between electrode 20 and electrode 30 (grounded electrode) by application of a voltage to electrode 20. End face portion 21 opposes side surface 42 (Fig. 5) of piezoelectric layer 40 and makes contact with side surface 42. An end portion 21T of end face portion 21 is a section of electrode 20 which is located at the joining surface side (at the adhesive 64 side). End portion 21T has a shape extending along a part of a lower end portion of side surface 42 in the longer side direction of piezoelectric element 50. In the present embodiment and the embodiments described below, the above-described joining surface corresponds to the bonding surface in the claims.

Upper surface portion 22 of electrode 20 is provided being continuously connected to an end portion of end face portion 21 at the arrow Z direction side and is arranged on upper surface 41 of piezoelectric layer 40. Intermediate portions 23 and 24 are sections of electrode 20 which are arranged inside piezoelectric layer 40, and are not visually recognized in a state in which piezoelectric element 50 is completed (see Fig. 5). An intermediate portion 33 of electrode 30 is arranged between intermediate portion 23 and intermediate portion 24 (see Fig. 8 to Fig. 10, and the like).

Hollowed portions 23H and 24H (Fig. 7) and cutout portions 23T and 24T are provided at the inner sides of intermediate portions 23 and 24, respectively. As illustrated in Fig. 7 and Fig. 9, end portions (specifically, end portions at the side where end face portion 21 is located) of intermediate portions 23 and 24 in the direction opposite to arrow X are connected to end face portion 21. On the other hand, end portions of intermediate portions 23 and 24 in the arrow X direction are not connected to an end face portion 31 of electrode 30, which will be described later, and are separated from end face portion 31. As illustrated in Fig. 3, electrode 20 and FPC 80 (wiring pattern 82) are electrically connected on a portion (connecting place 20C) between wiring pattern 82 provided in FPC 80 and upper surface portion 22 of electrode 20 (also see Fig. 4 and Fig. 5).

### (Electrode 30 (Grounded Electrode))

Electrode 30 as a grounded electrode includes end face portion 31, an upper surface portion 32, an intermediate portion 33, and a lower surface portion 34 (see Fig. 7). Electrode 30 functions as a common electrode. End face portion 31 opposes side surface 44 (Fig. 5) of piezoelectric layer 40 and makes contact with side surface 44. Lower surface portion 34 opposes lower surface 46 of piezoelectric layer 40 and makes contact with lower surface 46. Upper surface portion 32 is provided being continuously connected to an end portion of end face portion 31 at the arrow Z direction side and is arranged on upper surface 41 of piezoelectric layer 40. Intermediate portion 33 is a section of electrode 30 which is arranged inside piezoelectric layer 40, and is not visually recognized in the state in which piezoelectric element 50 is completed (see Fig. 5).

Hollowed portions 32H and 33H (Fig. 7) are provided at the inner sides of upper surface portion 32 and intermediate portion 33, respectively. Disk portion 11 of electrode 10 is arranged at the inner side of hollowed portion 32H (see Fig. 5). Cutout portions 32T and 33T are also provided at the inner sides of upper surface portion 32 and intermediate portion 33, respectively. Extending portion 12 of electrode 10 is arranged at the inner side of cutout portion 32T (see Fig. 5). A retracted portion 32F is provided on a portion of upper surface portion 32 in the direction opposite to arrow Y. Retracted portion 32F is a section for permitting arrangement of upper surface portion 22 of electrode 20.

As illustrated in Fig. 7 and Fig. 9, end portions of upper surface portion 32, intermediate portion 33, and lower surface portion 34 in the arrow X direction are connected to end face portion 31. On the other hand, end portions of upper surface portion 32, intermediate portion 33, and lower surface portion 34 in the direction opposite to arrow X are not connected to end face portion 21 of electrode 20 and are separated from end face portion 21. As illustrated in Fig. 3, electrode 30 and FPC 80 (wiring pattern 83) are electrically connected on a portion (connecting place 30C) between wiring pattern 83 provided in FPC 80 and upper surface portion 32 of electrode 30 (also see Fig. 4 and Fig. 5).

### (Transmission Region and Reception Region)

Referring to Fig. 8 to Fig. 10, a transmission region 40N and a reception region 40M are formed in piezoelectric layer 40. Transmission region 40N has a four-layer structure formed of first piezoelectric layers N1 to N4. First piezoelectric layers N1 to N4 are laminated in the direction of being distanced from bottom portion 62 of case 60 and are electrically connected in parallel by electrode 20 and electrode 30. Outlined arrows in Fig. 8 to Fig. 10 indicate polarization directions of the respective piezoelectric layers. On the other hand, reception region 40M has a one-layer structure formed of a second piezoelectric layer M1.

Lower surface portion 34 of electrode 30 has a shape extending over both transmission region 40N and reception region 40M. Upper surface portion 22 of electrode 20 opposes lower surface portion 34 of electrode 30 with transmission region 40N including first piezoelectric layers N1 to N4 interposed therebetween. Disk portion 11 of electrode 10 opposes lower surface portion 34 of electrode 30 with reception region 40M including second piezoelectric layer M1 interposed therebetween.

That is to say, a region between upper surface portion 22 of electrode 20 and lower surface portion 34 of electrode 30, a region between intermediate portion 23 of electrode 20 and upper surface portion 32 of electrode 30, and a region between intermediate portion 23 of electrode 20 and lower surface portion 34 of electrode 30 in piezoelectric layer 40 function as transmission region 40N. On the other hand, a region between disk portion 11 of electrode 10 and lower surface portion 34 of electrode 30 in piezoelectric layer 40 functions as reception region 40M.

As illustrated in Fig. 8 and Fig. 10, transmission region 40N and reception region 40M are formed at positions adjacent to each other in the surface direction (X-Y plane direction) of inner bottom surface 62S of bottom portion 62 of case 60. To be specific, reception region 40M is provided at a center portion of piezoelectric layer 40 and transmission region 40N is provided on a peripheral portion as an outer side portion relative to reception region 40M in the radial direction so as to surround reception region 40M.

As illustrated in Fig. 9 and Fig. 10, in piezoelectric element 50 configured as described above, lower surface portion 34 of electrode 30 (grounded electrode) and end portion 21T of end face portion 21 of electrode 20 (ungrounded electrode) are located at the joining surface side of piezoelectric element 50 (at the side of the surface of piezoelectric element 50 joined to bottom portion 62 of case 60). Lower surface portion 34 of electrode 30 is attached to bottom portion 62 (inner bottom surface 62S) of case 60 using adhesive 64. As described above, electrode 20 forms a potential difference between electrode 20 and electrode 30 (grounded electrode) by application of a voltage to electrode 20. As a result, ultrasonic sensor 100 can transmit ultrasonic waves.

Fig. 11 is a plan view illustrating a state when bottom portion 62 (inner bottom surface 62S) of case 60 is seen along a direction perpendicular to bottom portion 62. For the convenience of illustration, piezoelectric element 50 and end face portion 21 (end portion 21T) of electrode 20 are illustrated by a dotted line in Fig. 11.

A recessed portion 68 is formed in bottom portion 62 of case 60 in the present embodiment (also see Fig. 9 and Fig. 10). Recessed portion 68 has a groove-like shape extending linearly. Although recessed portion 68 having a rectangular shape in a cross-sectional view is provided in the present embodiment, recessed portion 68 may have a semicircular shape, a triangular shape, a trapezoidal shape, or a semi-elliptical shape in a cross-sectional view.

In a plan view of electrode 20 along the direction perpendicular to bottom portion (inner bottom surface 62S) of case 60, end portion 21T of end face portion 21 of electrode 20 located at the joining surface side is located to overlap with recessed portion 68. In other words, when end portion 21T is projected along the direction perpendicular to bottom portion 62 (inner bottom surface 62S) of case 60, a projected image formed as a result of projection is located to overlap with recessed portion 68. In a plan view of electrode 20 along the direction perpendicular to bottom portion 62 (inner bottom surface 62S) of case 60, end portion 21T may be preferably located to be included inside recessed portion 68 as illustrated in Fig. 11 (in this case, the entire projected image described above is included inside recessed portion 68).

### (Actions and Effects)

The general ultrasonic sensor including the multilayer piezoelectric element has the characteristics that as the number of laminated layers of the piezoelectric element is larger, the sound pressure in the transmission is increased whereas the sensitivity in the reception is decreased. The characteristics are provided because in the general multilayer piezoelectric element, a portion of the piezoelectric element which is provided for the transmission and a portion thereof which is provided for the reception are formed in the same section.

In the present embodiment, the portion (transmission region 40N) of piezoelectric element 50 that is provided for the transmission and the portion (reception region 40M) thereof which is provided for the reception are formed separately from each other. The four-layer structure, in which the number of laminated layers is four, is employed for the portion (transmission region 40N) of piezoelectric element 50 which is provided for the transmission in order to increase the sound pressure in the transmission, whereas the one-layer structure is employed for the portion (reception region 40M) thereof which is provided for the reception. The ultrasonic sensor in the present embodiment suppresses lowering in the sensitivity in the reception in comparison with the conventional configuration. Accordingly, it can be said that the ultrasonic sensor in the present embodiment has a structure capable of adjusting both the sound pressure in the transmission and the sensitivity in the reception independently of each other.

Referring to Fig. 9 and Fig. 10, as described in the beginning, when multilayer piezoelectric element 50 is joined to inner bottom surface 62S of bottom portion 62 of case 60 having conductivity, electrode 30 (grounded electrode) and end portion 21T of electrode 20 (ungrounded electrode) that forms a potential difference between the grounded electrode and the ungrounded electrode by application of a voltage are located at the joining surface side of piezoelectric element 50. In the conventional ultrasonic sensor, case 60 having conductivity and the end portion of electrode 20 establish electrical conduction (short circuit) due to a short distance between case 60 and the end portion of electrode 20, and a counter electrode circuit (an electrical circuit for forming the ultrasonic sensor) is not appropriately formed in some cases.

In contrast, in ultrasonic sensor 100 in the present embodiment, electrical conduction established by electrode 20 (ungrounded electrode) and case 60 is suppressed by the presence of recessed portion 68. Therefore, case 60 and electrode 20 are insulated from each other and a counter electrode circuit is formed. Therefore, ultrasonic sensor 100 can function appropriately and a probability of occurrence of initial failure immediately after manufacturing can be reduced. Electrode 30 as a grounded electrode and bottom portion 62 of case 60 may establish electrical conduction.

When ultrasonic sensor 100 is driven, piezoelectric element 50 performs bending vibration together with bottom portion 62. If recessed portion 68 is not provided, case 60 and electrode 20 may establish electrical conduction after the start of use due to the bending vibration, which may lead to occurrence of failure. According to ultrasonic sensor 100 in the present embodiment, the occurrence of such a trouble can also be suppressed by the presence of recessed portion 68. The presence of recessed portion 68 may affect a vibration mode of ultrasonic sensor 100. Therefore, a depth, a length, a width and the like of recessed portion 68 may be optimized so as to prevent occurrence of unnecessary electrical conduction and obtain an optimum vibration mode.

Measures to prevent electrical conduction described in the first embodiment may also be taken by devising the shape of the piezoelectric element (e.g., electrode 20). However, it can be said that when a thin multilayer element is used, the measures in which recessed portion 68 is provided in case 60 as described in the present embodiment can be performed more easily. Furthermore, in addition to provision of recessed portion 68 in case 60, it is also effective to prevent occurrence of unnecessary electrical conduction by devising the shape of the piezoelectric element (e.g., electrode 20).

### Experiment Example

In order to verify the effects produced by the above-described first embodiment, the following experiment was conducted. Specifically, a case having a diameter of 14 mm and a height of 9 mm was prepared as case 60 made of metal. A thickness of bottom portion 62 of case 60 was set at 0.9 mm. A shape of recessed portion 68 provided in bottom portion 62 of case 60 was set to have a length of 6.5 mm, a width of 0.5 mm and a depth of 0.05 mm.

A piezoelectric element having a length of 6 mm, a width of 5 mm and a thickness of 0.2 mm was prepared as multilayer piezoelectric element 50. As the wiring member, a lead wire was used instead of the FPC, an epoxy resin (insulating adhesive) was used as adhesive 64, and silicone was used as fillers 71 and 72 (see Fig. 2).

Ten ultrasonic sensors 100 each having the above-described configuration were manufactured. Then, the number of ultrasonic sensors 100 in which initial failure occurred (electrical conduction occurred immediately after manufacturing) was zero. Even when only the depth of recessed portion 68 was changed to 0.035 mm and 0.06 mm, similar effects were obtained. As long as the depth of recessed portion 68 with respect to the thickness (900 µm) of bottom portion 62 of case 60 was not less than 3% and not more than 6%, the excellent result was obtained. In addition, a through hole was provided in bottom portion 62 of case 60 instead of recessed portion 68 and a similar experiment was conducted. Then, the initial failure rate was improved. However, the frequency, directivity and vibration mode of the ultrasonic sensor varied and the sound pressure was less likely to be obtained in comparison with the case of providing the recessed portion.

### Second Embodiment

In the above-described first embodiment (see Fig. 11), one recessed portion 68 is provided in bottom portion 62 of case 60.

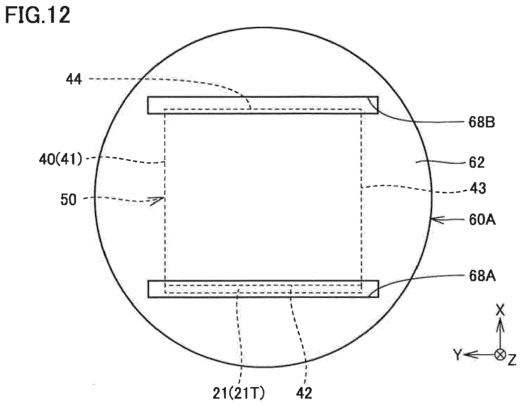

Like a case 60A illustrated in Fig. 12, two recessed portions 68A and 68B may be provided in bottom portion 62. Recessed portions 68A and 68B have the same shape and are parallel to each other. With this configuration, the direction of piezoelectric element 50 is not necessarily taken into consideration when piezoelectric element 50 is attached to bottom portion 62, and thus, increase in production efficiency can be expected.

### Third Embodiment

In the above-described first embodiment, end portion 21T of electrode 20 has a shape extending along the lower end portion of the side surface (side surface 42 of piezoelectric layer 40) in the longer side direction of piezoelectric element 50.

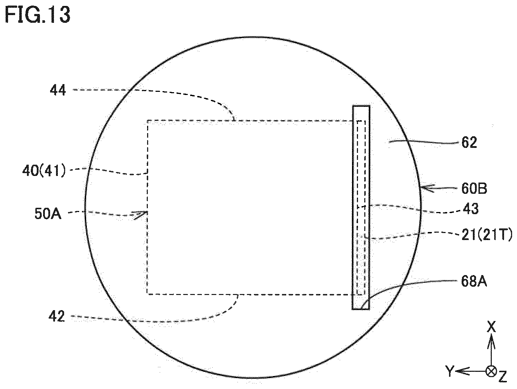

Referring to Fig. 13, in a piezoelectric element 50A in the present embodiment, end portion 21T of electrode 20 has a shape extending along the lower end portion of the side surface (side surface 43 of piezoelectric layer 40) in the shorter side direction of piezoelectric element 50A. Even when such piezoelectric element 50A is used, unnecessary electrical conduction can be prevented because end portion 21T of end face portion 21 of electrode 20 located at the joining surface side is located to overlap with recessed portion 68A of a case 60B. Like case 60B illustrated in Fig. 13, end portion 21T may preferably be located to be included inside recessed portion 68A.

### Fourth Embodiment

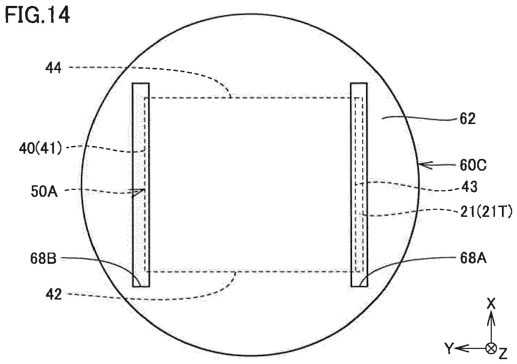

Referring to Fig. 14, in the present embodiment as well, end portion 21T of electrode 20 has a shape extending along the lower end portion of the side surface (side surface 43 of piezoelectric layer 40) in the shorter side direction of piezoelectric element 50A. Similarly to the above-described second embodiment, two recessed portions 68A and 68B are provided in bottom portion 62 of a case 60C. Recessed portions 68A and 68B have the same shape and are parallel to each other. With this configuration, the direction of piezoelectric element 50A is not necessarily taken into consideration when piezoelectric element 50A is attached to bottom portion 62, and thus, increase in production efficiency can be expected.

### Fifth Embodiment

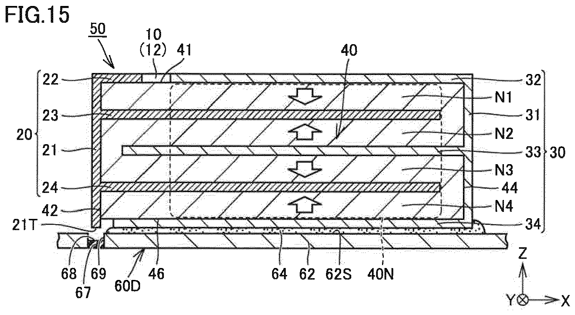

Referring to Fig. 15, in a case 60D in the present embodiment, a through hole 69 is provided in bottom portion 62 of case 60D and a resin 67 (such as an epoxy resin) is filled into through hole 69 to form recessed portion 68. With this configuration as well, actions and effects substantially similar to those obtained in the above-described embodiments can be obtained.

### Sixth Embodiment

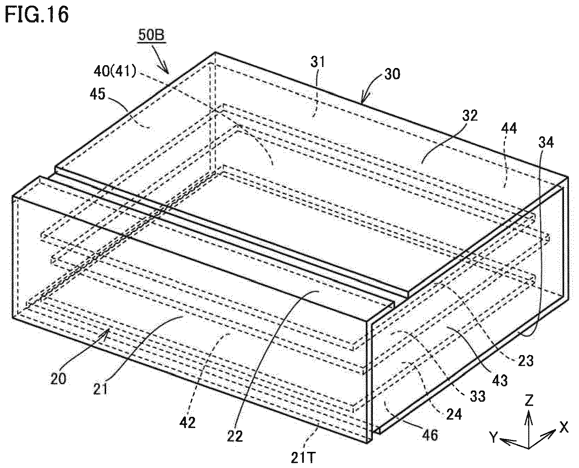

In the piezoelectric element (see Fig. 8, for example) included in the ultrasonic sensor in each of the above-described embodiments, transmission region 40N and reception region 40M are formed at positions adjacent to each other in the surface direction of inner bottom surface 62S of bottom portion 62 of the case. The idea disclosed in the above-described embodiments (i.e., the idea of providing the recessed portion in the inner bottom surface of the case) is applicable not only to the ultrasonic sensor including the above-described piezoelectric element but also to an ultrasonic sensor including a piezoelectric element 50B illustrated in Fig. 16.

As illustrated in Fig. 16, piezoelectric element 50B in the present embodiment does not include electrode 10, and the portion provided for the transmission and the portion provided for the reception are not separated from each other. Even when such piezoelectric element 50B is used, electrical conduction established by electrode 20 via end portion 21T can be suppressed because recessed portion 68 is formed in bottom portion 62 of the case (not illustrated).

### Other Embodiments

Although the piezoelectric element is made of PZT-based ceramics in each of the above-described embodiments, the piezoelectric element is not limited to be made thereof. For example, the piezoelectric element may be made of a piezoelectric material of non-lead-based piezoelectric ceramics such as potassium sodium niobate-based ceramics, alkali niobate-based ceramics, or the like. Although the piezoelectric element has a rectangular parallelepiped shape including a longer side direction and a shorter side direction in each of the above-described embodiments, the shape of the piezoelectric element is not limited thereto. For example, the piezoelectric element may have a circular plate shape. Although fillers 71 and 72 (Fig. 2) are made of silicone resin in each of the above-described embodiments, fillers 71 and 72 are not limited to be made thereof. For example, fillers 71 and 72 may be made of urethane resin or silicone foam resin as long as they are made of resin.

Although the embodiments and the experiment example according to the present invention have been described above, the disclosure above is illustrative and not limitative in any respect. The technical scope of the present invention is defined by the terms of the claims, and is intended to include any modifications within the scope and meaning equivalent to the terms of the claims.

### REFERENCE SIGNS LIST

1 sensor device; 10 electrode (common electrode); 10C, 20C, 30C connecting place; 11 disk portion; 12 extending portion; 20 electrode (ungrounded electrode); 21, 31 end face portion; 21T end portion; 22, 32 upper surface portion; 23, 24, 33 intermediate portion; 23H, 23T, 24H, 24T, 32H, 32T, 33H, 33T portion; 30 electrode (grounded electrode); 32F retracted portion; 34 lower surface portion; 40, M1, N1, N4 piezoelectric layer; 40M reception region; 40N transmission region; 41 upper surface; 42, 43, 44, 45 side surface; 46 lower surface; 50, 50A, 50B piezoelectric element; 60, 60A, 60B, 60C, 60D case; 61 cylindrical portion; 62 bottom portion; 62S inner bottom surface; 62T outer surface; 63 sound absorbing material; 64 adhesive; 65 bonding agent; 67 resin; 68, 68A, 68B recessed portion; 69 through hole; 71, 72 filler; 80T leading end portion; 81, 82, 83 wiring pattern; 100 ultrasonic sensor; 101 microcomputer; 102 memory; 103 detecting circuit; 104 signal generation circuit; 105 power supply; 106 reception amplifier.

## Claims

1. An ultrasonic sensor (100) comprising:
a case (60) having electrical conductivity and having a cylindrical shape (61) with a bottom (62); and
a piezoelectric element (50) bonded to an inner bottom surface (62S) of the case (60),
a grounded electrode (30) and an ungrounded electrode (20) configured to form a potential difference between the grounded electrode (30) and the ungrounded electrode (20) by application of a voltage to the ungrounded electrode, a lower surface portion (34) of the grounded electrode being located at a bonding surface side (46) of the piezoelectric element,
a recessed portion (68) being formed in the inner bottom surface (62S) of the case (60),
in a plan view of the ungrounded electrode (20) and the recessed portion (68) along a direction perpendicular to the inner bottom surface (62S) of the case,
**characterized in that** the piezoelectric element (50) is a multilayer piezoelectric element, and **in that** an end portion (21T) of the ungrounded electrode (20) located at the bonding surface side (46) is located to overlap with the recessed portion (68).

2. The ultrasonic sensor according to claim 1, wherein
in a plan view of the ungrounded electrode (20) and the recessed portion (68) along the direction perpendicular to the inner bottom surface of the case, the end portion of the ungrounded electrode (20) located at the bonding surface side is located to be included inside the recessed portion (68).

3. The ultrasonic sensor according to claim 1 or 2, wherein
the piezoelectric element (50) has a rectangular parallelepiped shape including a longer side direction and a shorter side direction, and
the end portion of the ungrounded electrode (20) located at the bonding surface side has a shape extending along the longer side direction of the piezoelectric element (50).

4. The ultrasonic sensor according to claim 1 or 2, wherein
the piezoelectric element (50) has a rectangular parallelepiped shape including a longer side direction and a shorter side direction, and
the end portion of the ungrounded electrode (20) located at the bonding surface side has a shape extending along the shorter side direction of the piezoelectric element (50).

5. The ultrasonic sensor according to any one of claims 1 to 4, wherein
a through hole (69) is provided in a bottom portion of the case and a resin (67) is filled into the through hole (69) to form the recessed portion (68).

6. The ultrasonic sensor according to any one of claims 1 to 5, wherein
the piezoelectric element (50) has:
a piezoelectric layer (40) including a transmission region (40N) and a reception region (40M);
a common electrode (30) having a shape extending over both the transmission region and the reception region;
a transmission electrode (20) opposing the common electrode (30) with the transmission region interposed therebetween; and
a reception electrode (10) opposing the common electrode (30) with the reception region interposed therebetween, and
the transmission region and the reception region are formed at positions adjacent to each other in a surface direction of the inner bottom surface.

## Patentansprüche

1. Ultraschallsensor (100), der Folgendes aufweist:
ein Gehäuse (60), das elektrische Leitfähigkeit hat und eine zylindrische Form (61) mit einem Boden (62) hat; und
ein piezoelektrisches Element (50), das an eine innere Bodenfläche (62S) des Gehäuses (60) angefügt ist,
eine geerdete Elektrode (30) und eine ungeerdete Elektrode (20), die zum Bilden einer Potentialdifferenz zwischen der geerdeten Elektrode (30) und der ungeerdeten Erde (20) durch Anlegen einer Spannung an die ungeerdete Elektrode konfiguriert sind, wobei ein unterer Oberflächenteil (34) der geerdeten Elektrode an einer Anfügungsflächenseite (46) des piezoelektrischen Elements liegt,
einen ausgesparten Teil (68), der in der inneren Bodenfläche (62S) des Gehäuses (60) in einer Draufsicht der ungeerdeten Elektrode (20) und des ausgesparten Teils (68) entlang einer Richtung, die zur inneren Bodenfläche (62S) des Gehäuses lotrecht ist, gebildet ist,
**dadurch gekennzeichnet, dass** das piezoelektrische Element (50) ein mehrschichtiges piezoelektrisches Element ist und dass ein Endteil (21T) der ungeerdeten Elektrode (20), der an der Fügeflächenseite (46) liegt, zum Überlappen des ausgesparten Teils (68) positioniert ist.

2. Ultraschallsensor nach Anspruch 1, wobei
in einer Draufsicht der ungeerdeten Elektrode (20) und des ausgesparten Teils (68) entlang der Richtung, die zur inneren Bodenfläche des Gehäuses lotrecht ist, der Endteil der ungeerdeten Elektrode (20), der an der Fügeflächenseite liegt, so positioniert ist, dass er im Inneren des ausgesparten Teils (68) enthalten ist.

3. Ultraschallsensor nach Anspruch 1 oder 2, wobei
das piezoelektrische Element (50) die Form eines rechteckigen Parallelepipeds hat, das eine Richtung einer längeren Seite und eine Richtung einer kürzeren Seite aufweist, und
der Endteil der ungeerdeten Elektrode (20), der an der Fügeflächenseite liegt, eine Form hat, die sich entlang der Richtung der längeren Seite des piezoelektrischen Elements (50) erstreckt.

4. Ultraschallsensor nach Anspruch 1 oder 2, wobei
das piezoelektrische Element (50) die Form eines rechteckigen Parallelepipeds hat, das eine Richtung einer längeren Seite und eine Richtung einer kürzeren Seite aufweist, und
der Endteil der ungeerdeten Elektrode (20) an der Fügeflächenseite liegt, eine Form hat, die sich entlang der Richtung der kürzeren Seite des piezoelektrischen Elements (50) erstreckt.

5. Ultraschallsensor nach einem der Ansprüche 1 bis 4, wobei
ein Durchgangsloch (69) in einem Bodenteil des Gehäuses bereitgestellt ist und ein Harz (67) in das Durchgangsloch (69) gefüllt ist, um den ausgesparten Teil (68) zu bilden.

6. Ultraschallsensor nach einem der Ansprüche 1 bis 5, wobei
das piezoelektrische Element (50) Folgendes hat:
eine piezoelektrische Schicht (40), die eine Senderegion (40N) und eine Empfangsregion (40M) enthält;
eine Masseelektrode (30) eine Form hat, die sich sowohl über die Senderegion als auch die Empfangsregion erstreckt;
eine Sendeelektrode (20), die der Masseelektrode (30) gegenüberliegt, wobei die Senderegion zwischen ihnen angeordnet ist; und
eine Empfangselektrode (10), die der Masseelektrode (30) gegenüberliegt, wobei die Empfangsregion zwischen ihnen angeordnet ist, und
die Senderegion und die Empfangsregion an in einer Oberflächenrichtung der inneren Bodenfläche nebeneinanderliegenden Positionen gebildet sind.

## Revendications

1. Capteur à ultrasons (100) comprenant :
un boîtier (60) ayant une conductivité électrique et ayant une forme cylindrique (61) avec un fond (62) ;
et
un élément piézoélectrique (50) lié à une surface de fond interne (62S) du boîtier (60),
une électrode mise à la terre (30) et un électrode non mise à la terre (20) configurées pour former une différence de potentiel entre l'électrode mise à la terre (30) et l'électrode non mise à la terre (20) par l'application d'une tension à l'électrode non mise à la terre, une partie de la surface inférieure (34) de l'électrode mise à la terre étant située à un côté de la surface de liaison (46) de l'élément piézoélectrique,
une partie en creux (68) étant formée dans la surface de fond interne (62S) du boîtier (60), dans une vue plane de l'électrode non mise à la terre (20) et de la partie en creux (68) le long d'une direction perpendiculaire à la surface de fond interne (62S) du boîtier,
**caractérisé en ce que** l'élément piézoélectrique (50) est un élément piézoélectrique multicouche, et **en ce qu'**une partie d'extrémité de l'électrode non mise à la terre (20) située au côté de la surface de liaison (46) est disposée pour chevaucher la partie en creux (68).

2. Capteur à ultrasons selon la revendication 1, dans lequel
dans une vue plane de l'électrode non mise à la terre (20) et de la partie en creux (68) le long d'une direction perpendiculaire à la surface de fond interne du boîtier, la partie d'extrémité de l'électrode non mise à la terre (20) située au côté de la surface de liaison est disposée pour être incluse à l'intérieur de la partie en creux (68).

3. Capteur à ultrasons selon la revendication 1 ou 2, dans lequel
l'élément piézoélectrique (50) a une forme de parallélépipède rectangulaire comprenant une direction de côté plus long et une direction de côté plus court, et
la partie d'extrémité de l'électrode non mise à la terre (20) située au côté de la surface de liaison a une forme s'étendant le long de la direction du côté plus long de l'élément piézoélectrique (50).

4. Capteur à ultrasons selon la revendication 1 ou 2, dans lequel
l'élément piézoélectrique (50) a une forme de parallélépipède rectangulaire comprenant une direction de côté plus long et une direction de côté plus court, et
la partie d'extrémité de l'électrode non mise à la terre (20) située au côté de la surface de liaison a une forme s'étendant le long de la direction du côté plus court de l'élément piézoélectrique (50).

5. Capteur à ultrasons selon l'une quelconque des revendications 1 à 4, dans lequel un trou traversant (69) est fourni dans une partie de fond du boîtier et une résine (67) est chargée dans le trou traversant (69) pour former la partie en creux (68).

6. Capteur à ultrasons selon l'une quelconque des revendications 1 à 5, dans lequel
l'élément piézoélectrique (50) a :
une couche piézoélectrique (40) comprenant une région de transmission (40N) et une région de réception (40M) ;
une électrode commune (30) ayant une forme s'étendant au-dessus de la région de transmission et de la région de réception toutes les deux ;
une électrode de transmission (20) à l'opposé de l'électrode commune (30) avec la région de transmission interposée entre elles ; et
une électrode de réception (10) à l'opposé de l'électrode commune (30) avec la région de réception interposée entre elles, et
la région de transmission et la région de réception sont formées à des positions adjacentes l'une à l'autre dans une direction de surface de la surface de fond interne.
